Europäisches Patentamt

European Patent Office

Office européen des brevets

(19)

(11) Publication number: **0 066 042**

A2

(12) **EUROPEAN PATENT APPLICATION**

(21) Application number: 82101676.3

(22) Date of filing: 04.03.82

(51) Int. Cl.³: **H 01 L 21/76**
**H 01 L 21/306, H 01 L 21/316**

(30) Priority: 26.05.81 US 267483

(43) Date of publication of application:
08.12.82 Bulletin 82/49

(84) Designated Contracting States:
DE FR GB IT

(71) Applicant: International Business Machines
Corporation

Armonk, N.Y. 10504(US)

(72) Inventor: Lever, Reginald Frank
RD 1, Box 270 Peekshill Hollow Road
Putnam Valley New York 10579(US)

(72) Inventor: Raacke, Karl Heinz
46 Mansfield Avenue
Essex Junction Vermont 05452(US)

(74) Representative: Hobbs, Francis John
IBM United Kingdom Patent Operations Hursley Park
Winchester Hants, SO21 2JN(GB)

(54) Methods of processing a silicon substrate for the formation of an integrated circuit therein.

(57) A region of a silicon substrate is simultaneously etched
and a silicon dioxide deposit formed on the sidewalls of the
etched region by masking the substrate except in the region
to be etched and subjecting the substrate to a plasma in a
gas containing a fluorohalogenohydrocarbon and oxygen,
the oxygen content being between 40 and 80 percent by
volume. Thus, a trench (36) is plasma etched in a region of a
silicon substrate (30) not protected by a masking layer (32)
and a silicon dioxide deposit (34) is formed on the sidewalls
of the trench (36). The fluorohalogenohydrocarbon may be
$CCl_2F_2$. Other hydrocarbons containing chlorine or bromine
or iodine, as well as fluorine, may also be used.

FIG 4

EP 0 066 042 A2

Croydon Printing Company Ltd.

## METHODS OF PROCESSING A SILICON SUBSTRATE FOR THE FORMATION
## OF AN INTEGRATED CIRCUIT THEREIN

This invention relates to methods of processing a silicon substrate for the formation of an integrated circuit therein and provides a method for simultaneously etching a silicon substrate and forming a silicon dioxide deposit.

It is known that small percentages of oxygen for example, between five and twenty percent of concentration, can be added to an etching gas to enhance the etching rate. In the publication entitled "RF Sputter-Etching by Fluro-Chloro-Hydrocarbon Gases" by N. Hosokawa, R. Matsuzaki and T. Asamaki, Proc. 6th Intl. Vacuum Congr. 1974, Japanese J. Appl. Phys. Suppl. 2 Part 1, (1974) p435-438, the effect of oxygen in combination with fluro-chloro-hydro-carbon sputtering gases was reported. More particularly, this publication describes how the addition of oxygen to $CCl_2F_2$ increases the etching rate of a silicon wafer up to a point of 12.5% oxygen, after which the etching rate decreased with increased oxygen concentration. Similar results were obtained using $CCl_2FCClF_2$ plus oxygen but with lower etching rates. In the publication, a plain silicon wafer was employed.

US patent 3,984,301 entitled "Sputter-Etching Method Employing Fluorohalogenhydrocarbon Etching Gas and a Planar Electrode for a Glow Discharge", contains substantially the same disclosure as the aforesaid publication. The method disclosed therein does not involve use of a mask and does not produce silicon dioxide coated sidewalls of an etched region.

The present invention differs from the prior art in that it enables the simultaneous etching of a limited portion of a silicon substrate and the formation of a silicon dioxide deposit on the sidewalls of the etched portion of the substrate.

A method of processing a silicon substrate for the formation of an integrated circuit therein, including covering all except a limited portion of the silicon substrate with a masking layer, is characterised, according to the invention, by simultaneously plasma etching a trench in said limited portion of the substrate and forming a deposit of silicon dioxide on the sidewalls of the trench.

How the invention can be carried out will now be descibred by way of example, with reference to the accompanying drawings, in which:-

Fig. 1 is a schematic illustration of a typical known reactive ion etching system which may be used in carrying out a method according to the invention; and

Figs. 2, 3, 4 and 5 are schematic illustrations of a cross-sectional view of a silicon wafer and mask in successive stages in the simultaneous etching and silicon dioxide deposition process of the present invention.

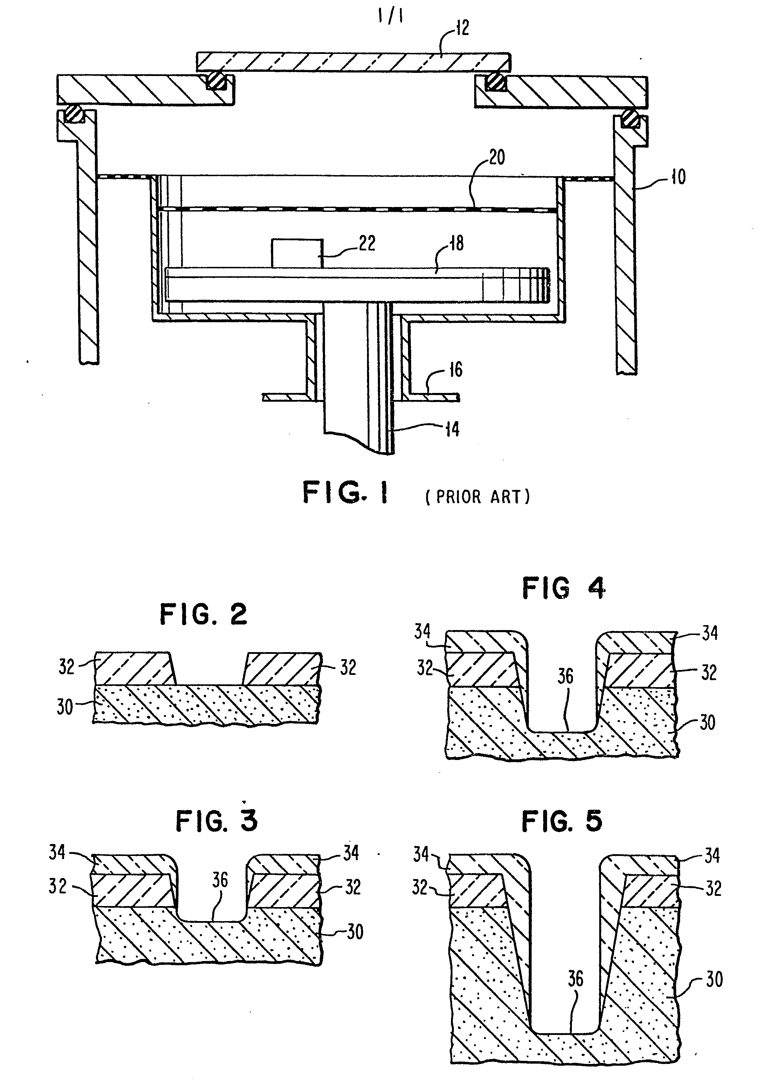

The present invention is concerned with a process for etching a silicon wafer through a mask to produce $SiO_2$ deposition as well as an etched region. Fig. 1 illustrates a typical apparatus which may be used to carry out the etching process. The reactive ion etching system of Fig. 1 includes a vacuum chamber 10 with an observation window 12 in which are located an RF driven electrode 14 with ground shield 16, an aluminium or $SiO_2$ top plate 18 and a perforated counter electrode 20. The specimen 22 to be etched is located on the surface of top plate 18. The system of Fig. 1 is operated at a typical pressure of 25 m Torr and power of $0.3W/cm^2$.

A cross-sectional view of the specimen 22 prior to etching is shown in Fig. 2 including silicon wafer substrate 30 and mask 32. Mask 32, which may be composed of silicon dioxide or photoresist material, is shown in Fig. 2 as having already been patterned by photolithographic or another conventional technique. The mask 32 opening provides access to the surface of silicon substrate 30 which is to be etched to form, for example, a deep trench. Mask 32 may also be composed of multiple layers of material, for example, a layer of polysilicon beneath a layer of silicon dioxide.

In Fig. 3, an in situ deposition 34 of $SiO_2$ forms simultaneously as the silicon is etched away to form trench 36. The etching gas for this example is composed of 40% $CCl_2F_2$ and 60% $O_2$. The chlorine in the etch gas reacts with the silicon to produce, for example, $SiCl_4$ as the silicon is etched away. At the same time the $SiCl_4$ reacts with the $O_2$ to produce $SiO_2 + 2 Cl_2$; silicon dioxide plus free chlorine. As shown in Fig. 3, the $SiO_2$ deposits on the mask and grows as the etching process continues. Figs. 4 and 5 show the continued etching and deposition process illustrating how the sidewalls of the etched trench become lined or coated with $SiO_2$. It has been observed that suitable $SiO_2$ depositions and etching will occur with oxygen concentrations between 40% and 80%, with preferred concentrations of oxygen in $CCl_2F_2$, in the range of 50% to 60%. The $CCl_2F_2$ gas is also known in the art as Freon 12. Other chlorine based gases such as $CCl_3F$ $(CCl_2F)_2$ and $CCl_2FCClF_2$ are also usable as are gases containing the less stable halogens bromine and iodine. Halocarbons, composed exclusively of fluorides, being too stable, are not suitable reactants.

The simultaneous formation of $SiO_2$ on the sidewalls as a trench is etched provides several advantages. First, as can be seen in Fig. 3, there is an $SiO_2$ buildup on top of the mask 32. This permits the use of a thin initial mask thickness on top of the structure, which will be built up during the etching process. Second, etching action on the sidewalls is inhibited by the $SiO_2$ layer thereon, so the etching trench becomes narrower with sloped sidewalls. This means that the etching bias at the bottom of the trench is positive and that the mask is not undercut.  The formation of sloped sidewalls without a mask undercut is useful if the trench is to be later refilled with chemically vapour deposited $SiO_2$ or other materials such as polyimides to form device isolation regions.  Third, in the vertical direction the $SiO_2$ is relatively thick, and may serve as a mask for later ion implantation at the bottom of the trench.

Fourth, in addition to the top surface, the lateral portions of the mask 34 are enhanced in thickness, and this sidewall buildup of masking oxide can be used in device formation, for example, to block the heavy source/drain implant of an FET and after removing the oxide a lightly doped drain implant can be made.

It should be noted that the pressure, power and oxygen concentration can be selected to provide different rates of deposition of $SiO_2$ versus rate of etching of silicon so that the slope of the trench sidewalls can be controlled.  In the embodiment shown in Figs. 2, 3, 4 and 5, 60% oxygen was used at a pressure of 25 m Torr and a power of $0.3W/cm^2$.

The $SiO_2$ deposition 34 has been found not to contain metals. Therefore, if desired, the $SiO_2$ deposition can be simply removed by etching in buffered HF.

CLAIMS

1.    A method of processing a silicon substrate for the formation of an integrated circuit therein, including covering all except a limited portion of the silicon substrate (30) with a masking layer (32), the method being characterised by simultaneously plasma etching a trench (36) in said limited portion of the substrate and forming a deposit of silicon dioxide (34) on the sidewalls of the trench.

2.    A method as claimed in claim 1, in which the simultaneous plasma etching of the trench and formation of the silicon dioxide deposit on the sidewalls of the trench is effected by plasma etching said limited portion of the silicon substrate with a gas containing a flurohalogenohydrocarbon and oxygen, the oxygen content being between 40 and 80 percent by volume.

3.    A method of processing a silicon substrate for the formation of an integrated circuit therein characterised by forming in the substrate a trench having a silicon dioxide deposit on the sidewalls thereof by subjecting a limited portion of the substrate exposed through a window in a masking layer on the substrate to a plasma formed in a gas containing a flurohalogenohydrocarbon and oxygen, the oxygen content being between 40 and 80 percent by volume.

4.    A method of processing a silicon substrate for the formation of an integrated circuit therein, including covering all except a limited portion of the silicon substrate with a masking layer, the method being characterised by subjecting the masked substrate to a plasma formed in a gas containing a fluorohalogenohydrocarbon and oxygen, the oxygen content being between 40 and 80 percent by volume, so that a trench is etched by the plasma in said limited portion of the substrate and a silicon dioxide deposit is formed on the sidewalls of the trench.

YO9-80-077                              6

5.    A method of processing a silicon substrate for the formation of an integrated circuit therein, comprising contacting the substrate with a plasma formed in a gas containing a fluorohalogenohydrocarbon and oxygen, the oxygen content being between 40 and 80 percent by volume characterised by covering all except a limited portion of the substrate with a masking layer so that a trench is etched by the plasma in said limited portion and a silicon dioxide deposit is formed on the sidewalls of the trench.

6.    A method as claimed in any preceding claim, in which a silicon dioxide deposit is also formed over the masking layer as etching of the limited portion of the substrate by the plasma progresses.

7.    A method as claimed in any preceding claim, in which the fluorohalogenohydrocarbon is a fluorochlorohydrocarbon.

8.    A method as claimed in claim 7, in which the gas contains 60 percent oxygen by volume and 40 percent $CCl_2F_2$.

0066042

1/1

FIG. 1 (PRIOR ART)

FIG. 2

FIG. 3

FIG 4

FIG. 5